# EUROPÄISCHE PATENTANMELDUNG

(11) **EP 4 485 486 A1**
(43) Veröffentlichungstag der Anmeldung: **01.01.2025**
(21) Anmeldenummer: 24183514.9
(22) Anmeldetag: 20.06.2024
(51) Int. Cl.: H01F 7/06, H01R 4/02, H05K 1/18, H05K 3/30, H05K 3/34

(54) **ELEKTROHYDRAULISCHER AKTUATOR UND VERFAHREN ZU SEINER HERSTELLUNG**

(30) Priorität: 30.06.2023 DE 102023206228
(71) Anmelder: Robert Bosch GmbH, 70442 Stuttgart (DE)
(72) Erfinder: Komar, Nandor, 1045 Budapest (HU); Varga, Eszter, 1052 Budapest (HU); Pozsega, Peter, 2011 Budakalasz (HU); Hittaller, Adam, 1103 Budapest (HU)

(57) **Zusammenfassung**

Die Erfindung betrifft einen elektrohydraulischen Aktuator (3) aufweisend einen Ventilteil (6), einen Elektromagneten (5) mit einer Spulenwicklung (23), einen in dem Elektromagneten (5) beweglich gelagerten Magnetanker (52) sowie ein von dem Magnetanker (52) betätigtes und in dem Ventilteil (6) angeordnetes Ventilglied (61). Wird vorgeschlagen, dass an dem elektrohydraulischen Aktuator (3) wenigstens eine Leiterplatte (1) angeordnet ist, wobei die Leiterplatte (1) auf einer dem Elektromagneten (5) zuweisenden Seite ein auf der Leiterplatte (1) montiertes Drahtführungselement (8) aufweist, wobei das Drahtführungselement (8) wenigstens eine Einfädelöffnung (81) aufweist, wobei ein Kontaktabschnitt (21) eines Anschlussdrahts (2) der Spulenwicklung (23) durch die Einfädelöffnung (81) des Drahtführungselementes (8) hindurchgeführt und in eine Kontaktierungsöffnung (41) der Leiterplatte (1) eingelötet ist. Weiterhin betrifft die Erfindung ein Verfahren zur Herstellung eines solchen elektrohydraulischen Aktuators (3).

## Beschreibung

### Stand der Technik

Im Stand der Technik sind elektrohydraulische Aktuatoren zur Steuerung in Hydrauliksystemen bekannt, die einen Elektromagneten mit einer Magnetspule und ein Ventilteil mit einem Ventilelement aufweisen. Das mittels des Elektromagneten betätigte Ventilelement kann verschiedenartig ausgebildete Einlass- und Auslassöffnungen an dem Ventilteil öffnen oder verschließen und dadurch eine Druckeinstellung an einem oder mehreren hydraulischen Verbrauchern oder einem Druckkanal vornehmen. Die Ansteuerung derartiger elektrohydraulischer Aktuatoren kann über ein Steuergerät erfolgen, welches den elektrischen Strom durch die Magnetspule des Elektromagneten einstellt.

Im Stand der Technik werden zur Ansteuerung der elektrohydraulischen Aktuatoren elektrohydraulische Steuervorrichtungen verwandt, die beispielsweise in der Kraftfahrzeugtechnik im Getriebe eingesetzt werden und in der Regel als komplexe Elektronikmodule mit Drucksensoren, Drehzahlsensoren und weiteren Funktionen ausgestaltet sind und der Ansteuerung mehrerer elektrohydraulischer Aktuatoren dienen können. So ist beispielsweise aus der DE 101 30 833 B4 eine elektrohydraulische Steuervorrichtung bekannt, die einen mit Hydraulikkanälen versehenen Hydraulikblock mit einer Bestückungsseite aufweist. An dem Hydraulikblock sind mehrere elektrohydraulische Aktuatoren angeordnet, die von der Bestückungsseite aus mit einem Ventilabschnitt in jeweils eine Aufnahmeöffnung des Hydraulikblocks eingreifen. Ein elektronisches Steuergerät umfasst eine als großflächige Verbindungsisolationslage mit darin eingebetteten Leiterbahnen ausgebildete Leiterplatte. Ein zentraler Abschnitt dieser Leiterplatte fungiert als Schaltungsträger und ist mit den elektronischen Bauelementen einer Steuerschaltung bestückt, die mit einem auf die Leiterplatte aufgesetzten Deckelteil abgedeckt sind. Die Leiterplatte ist seitlich über das Deckelteil nach außen geführt und weist an ihren Rändern elektrische Kontaktmittel auf, die jeweils mit den elektrischen Anschlüssen eines elektrohydraulischen Aktuators elektrisch kontaktiert sind.

Bei den bekannten Lösungen erfolgt die Ansteuerung aller Aktuatoren gewöhnlich über eine gemeinsame elektronische Steuereinheit (ECU = Electronic Control Unit), welche beispielsweise über einen Mikroprozessor die erforderlichen Stellströme für die Aktuatoren ermitteln kann und die Stellströme über in die Steuereinheit integrierte Endstufenbausteine für die Elektromagneten der Aktuatoren bereitstellt. Die ECU verfügt über mehrere Endstufen, so dass mehrere Aktuatoren über diese ECU angesteuert werden können.

Neue Entwicklungen und Einsatzfelder erfordern, dass die elektrohydraulischen Aktuatoren nicht mehr über einen Endstufenbaustein in einem zentralen Steuergerät betrieben werden, sondern vorzugsweise über ein BUS-System angesprochen werden (z.B. CAN oder LIN). Der für die Erzeugung der Stellkräfte notwendige Stellstrom muss dann jedoch im oder am Aktuator aus einer Batteriespannung erzeugt werden. Es besteht somit ein Bedarf an hydraulischen Aktuatoren (sogenannten "smart actuators"), die mit einem direkt in oder an dem Aktuator angeordneten und dem Aktuator zugeordneten elektronischen Steuergerät zu einer kleinen, flexibel einsetzbaren Baueinheit verbaut werden können.

Hierbei taucht die grundlegende Problematik auf, wie eine Spulenwicklung eines Elektromagneten des Aktuators elektrisch mit der Leiterplatte des elektronischen Steuergerätes beziehungsweise Steuerteils verbunden werden soll. Die Spulenwicklung eines Elektromagneten weist einen recht dünnen Draht auf, der eher biegeschlaff ist. Eine Montage des Anschlussdrahtes in der für Leiterplatten bekannten Durchsteckmontage in einer Kontaktierungsöffnung der Leiterplatte ähnlich zu den auf der Leiterplatte bestückten herkömmlichen elektronischen Drahtbauelementen ist daher in der Regel in einer automatisierten Fertigung kaum möglich.

Bekannte elektrische Verbindungstechniken zwischen den Anschlussdrähten der Spulenwicklung eines Elektromagneten und einer Leiterplatte verwenden aufwändig ausgestaltete Zwischenverbindungsmittel, um eine zuverlässige Kontaktierung zu erreichen. So zeigt beispielsweise die DE 44 27 767 C2 eine Spulenwicklung deren Anschlussdrähte um Anschlussstecker des Elektromagneten herumgewickelt und mit einem Spulengehäuse aus Kunststoff umspritzt werden. Frei liegende Enden der Anschlussstecker sind als Steckerfahnen aus dem Spulengehäuse herausgeführt. Die stabilen Steckerfahnen können zur Weiterkontaktierung mit der Leiterplatte verwandt werden, wobei hier weitere Kontaktelemente zwischen den Steckerfahnen und der Leiterplatte eingesetzt werden können.

Die DE 103 37 197 B4 offenbart beispielsweise eine Weiterkontaktierung über als Federelemente ausgebildet Kontaktelemente, welche als Teil des elektromagnetischen Aktuators mit der Spulenwicklung kontaktiert sind. Die federnden Kontaktelemente können mit ihren vom Aktuator abweisenden Enden an eine Metallisierungsfläche auf einer Leiterplatte angedrückt werden. Diese Lösungen beanspruchen jedoch sehr viel Bauraum.

### Offenbarung der Erfindung

Die Erfindung betrifft einen elektrohydraulischer Aktuator mit einem Ventilteil, einem Elektromagneten mit Spulenwicklung, einem in dem Elektromagneten beweglich gelagerten Magnetanker sowie einem von dem Magnetanker betätigten und in dem Ventilteil angeordneten Ventilglied. Es wird vorschlagen, dass an dem elektrohydraulischen Aktuator wenigstens eine Leiterplatte angeordnet ist, wobei die Leiterplatte auf einer dem Elektromagneten zuweisenden Seite ein auf der Leiterplatte montiertes Drahtführungselement aufweist, wobei das Drahtführungselement wenigstens eine Einfädelöffnung aufweist, wobei ein Kontaktabschnitt eines Anschlussdrahts der Spulenwicklung durch die Einfädelöffnung des Drahtführungselementes hindurchgeführt und in eine Kontaktierungsöffnung der Leiterplatte eingelötet ist.

Weiterhin betrifft die Erfindung ein Verfahren zur Herstellung eines solchen elektrohydraulischen Aktuators mit den folgenden Schritten:
- Bereitstellen einer Leiterplatte, wobei die Leiterplatte wenigstens eine Kontaktierungsöffnung aufweist,
- Bereitstellen eines elektrohydraulischen Aktuators aufweisend einen Ventilteil, einen Elektromagneten mit einer Spulenwicklung, einen in dem Elektromagneten beweglich gelagerten Magnetanker sowie ein von dem Magnetanker betätigtes und in dem Ventilteil angeordnetes Ventilglied, wobei der Elektromagnet in einem Aktuatorgehäuse aufgenommen ist und ein Kontaktabschnitt eines Anschlussdrahts der Spulenwicklung seitlich von dem Aktuatorgehäuse absteht,

- Bereitstellen eines Drahtführungselements, welches wenigstens eine Einfädelöffnung aufweist,
- Befestigen des Drahtführungselementes an der Leiterplatte, so dass die Einfädelöffnung koaxial zu der Kontaktierungsöffnung angeordnet ist,
- Aufsetzen der Leiterplatte auf das Aktuatorgehäuse, so dass der von dem Aktuatorgehäuse abstehende Kontaktabschnitt durch die Einfädelöffnung des Drahtführungselementes hindurchgeführt und in eine Kontaktierungsöffnung der Leiterplatte eingeführt wird und
- Einlöten des Kontaktabschnitts in der Kontaktierungsöffnung.

### Vorteile der Erfindung

Die Integration einer Steuerschaltung in einen elektromagnetischen Aktuator lässt sich nur mit einer zuverlässigen und einfach handhabbaren Lösung für die elektrische Verbindung zwischen der Leiterplatte und den Anschlussdrähten einer Spulenwicklung des im Aktuator verbauten Elektromagneten erreichen. Dies gilt insbesondere für automatisierte Fertigungsverfahren. Die hier vorgeschlagene Lösung verwendet ein Drahtführungselement, das insbesondere als einfaches Kunststoffteil preiswert herstellbar ist und in einfacher Weise an der Leiterplatte befestigt werden kann. Das Drahtführungselement dient dem vereinfachten Einführen eines Kontaktabschnitts eines Anschlussdrahtes der Spulenwicklung des Elektromagneten insbesondere in einer automatisierten Fertigungsanlage. Hierzu weist das Drahtführungselement eine Einfädelöffnung auf, welche es vorteilhaft erleichtert, beim Aufsetzen der Leiterplatte auf ein Aktuatorgehäuse des elektromagnetischen Aktuars einen Kontaktabschnitt eines biegeschlaffen Anschlussdrahts der Spulenwicklung, ohne dass dieser abknickt oder beschädigt wird, zuverlässig durch die Einfädelöffnung hindurch direkt in die dafür vorgesehene Kontaktierungsöffnung der Leiterplatte einzuführen und anschließen in der Kontaktierungsöffnung zu verlöten. Selbstverständlich ist dies für alle Anschlussdrähte der Spulenwicklung möglich, beispielsweise für zwei Anschlussdrähte, wobei dann das Drahtführungselement für jeden Anschlussdraht eine diesem zugeordnete Einführungsöffnung aufweist und die Leiterplatte eine entsprechende Anzahl an Kontaktierungsöffnungen aufweist. Das preiswerte Drahtführungselement kann als verlorene Form an der Leiterplatte verbleiben. Dadurch wird die Integration eines Steuergerätes in einen elektromagnetischen Aktuator ("smart actuator") vorteilhaft vereinfacht beziehungsweise ermöglicht.

Vorteilhafte Ausgestaltungen und Weiterbildungen der Erfindung ermöglichen die die in den abhängigen Ansprüchen enthaltenen Merkmale.

Vorteilhaft kann das Drahtführungselement wenigstens einen in die Leiterplatte eingepressten mit Quetschrippen versehenen Befestigungszapfen aufweisen und vorzugsweise aus Kunststoff gefertigt sein. Das Drahtführungselement kann mittels des Befestigungszapfens durch einen einfachen Pressvorgang in einer Befestigungsöffnung der Leiterplatte verbaut werden.

Besonders vorteilhaft ist es, wenn die Einfädelöffnung konusförmig mit einem der Leiterplatte zugewandten ersten Innendurchmesser und einem von der Leiterplatte abgewandten zweiten Innendurchmesser, der größer als der erste Innendurchmesser ist, ausgebildet ist. Bei einer relativen Annäherung der Leiterplatte an den Kontaktabschnitt des Anschlussdrahtes wird dieser entlang der konusförmigen Einfädelöffnung geführt und dabei automatisch derart zentriert, dass er direkt in die Kontaktierungsöffnung am Ende der Einfädelöffnung eingeführt werden kann. Dies ist besonders vorteilhaft für einen Anschlussdraht, der biegeschlaff ist und aus seiner Eigensteifigkeit heraus keine ausreichende Stabilität aufweist, um ein sicheres Einführen in die Kontaktierungsöffnung zu erreichen.

Die Leiterplatte kann in einfacher Weise auf seitlich abstehende Haltezapfen eines den Elektromagneten bergenden Aktuatorgehäuses aufgepresst werden. Dabei kann vorteilhaft gleichzeitig mit der Festlegung der Leiterplatte die Einfädelung des Anschlussdrahtes in die Kontaktierungsöffnung erfolgen. Die am Aktuatorgehäuse festgelegt Leiterplatte kann in einfacher Weise von einem an dem Aktuatorgehäuse montierten Gehäuseteil abgedeckt werden.

Besonders vorteilhaft ist eine Ausführungsform, bei welcher der Kontaktabschnitt des Anschlussdrahts der Spulenwicklung in einer Richtung in die Kontaktierungsöffnung eingeführt ist und Steckerfahnen eines Anschlusssteckers des elektrohydraulischen Aktuators in der gleichen Richtung in weitere Kontaktierungsöffnungen der Leiterplatte eingeführt sind. Dies erleichtert die Montage, da mit den gleichen Arbeitsschritten die elektrische Verbindung zwischen einerseits den Anschlussdrähten der Spulenwicklung und der Leiterplatte and andererseits zwischen den Kontaktfahnen eines Steckerteils und der Leitplatte erfolgen können. Da der elektrohydraulische Aktuator einen Anschlussstecker für den Außenanschluss aufweist, ist es möglich, dass die von den Außenkontakten abweisenden Enden der Steckerfahnen des Anschlusssteckers in der gleichen Richtung wie der Kontaktabschnitt des Anschlussdrahts der Spulenwicklung seitlich von dem Aktuatorgehäuse abstehen. Beim Aufsetzen der Leiterplatte auf das Aktuatorgehäuse (oder des Aktuatorgehäuses auf die Leiterplatte) kann dann vorteilhaft erreicht werden, dass mit der Einführung des Kontaktabschnitts des Anschlussdrahts in die Kontaktierungsöffnung der Leiterplatte, beziehungsweise mit der Einführung aller Kontaktabschnitt der Anschlussdrähte in die jeweiligen Kontaktierungsöffnungen der Leiterplatte in der gleichen Richtung gleichzeitig die Steckerfahnen des Anschlusssteckers in die weiteren Kontaktierungsöffnungen der Leiterplatte eingeführt werden. In diesem Zusammenhang kann vorteilhaft auch gleichzeitig das Aufpressen der Leiterplatte auf die oben beschriebenen Haltezapfen erfolgen.

Die mechanische Befestigung der Leiterplatte am Aktuator kann in einem gemeinsamen Arbeitsschritt mit der Einführung der elektrischen Kontakte der Spulenwicklung und der Steckerfahnen in die Kontaktierungsöffnungen und weiteren Kontaktierungsöffnungen der Leiterplatte erfolgen. Vorteilhaft kann der Kontaktabschnitt mit der Kontaktierungsöffnung und die Steckerfahnen mit den weiteren Kontaktierungsöffnungen in einem nachfolgenden Arbeitsschritt verlötet werden, wobei dies auch gemeinsam in einer Lötstation erfolgen kann.

Zuletzt kann ein die Leiterplatte abdeckendes Gehäuseteil über die Leiterplatte geschoben und an dem Aktuatorgehäuse gegebenenfalls unter Zwischenlage einer Dichtung befestigt wird. Das Gehäuseteil deckt beispielsweise alle elektrischen Kontakte und die Anschlussdrähte der Spulenwicklung ebenso wie das Drahtführungselement ab.

### Kurze Beschreibung der Zeichnungen

Nachfolgend werden mögliche Ausführungsformen der Erfindung unter Bezugnahme auf die beiliegenden Figuren erläutert. In der Zeichnung zeigen:
- Figur 1 und Figur 2: einen Querschnitt durch einer Leiterplatte während einer Abfolge von Verfahrensschritten zur Befestigung eines Drahtführungselementes an der Leiterplatte,
- Figur 3 und Figur 4: einen Querschnitt durch einen elektrohydraulischen Aktuator und die Leiterplatte während einer Abfolge von Verfahrensschritten zur Befestigung der Leiterplatte an dem elektrohydraulischen Aktuator,
- Figur 5: einen Querschnitt durch den mit dem in den Figuren 1 bis 4 dargestellten Verfahrensschritten hergestellten elektrohydraulischen Aktuator.

### Ausführungsformen der Erfindung

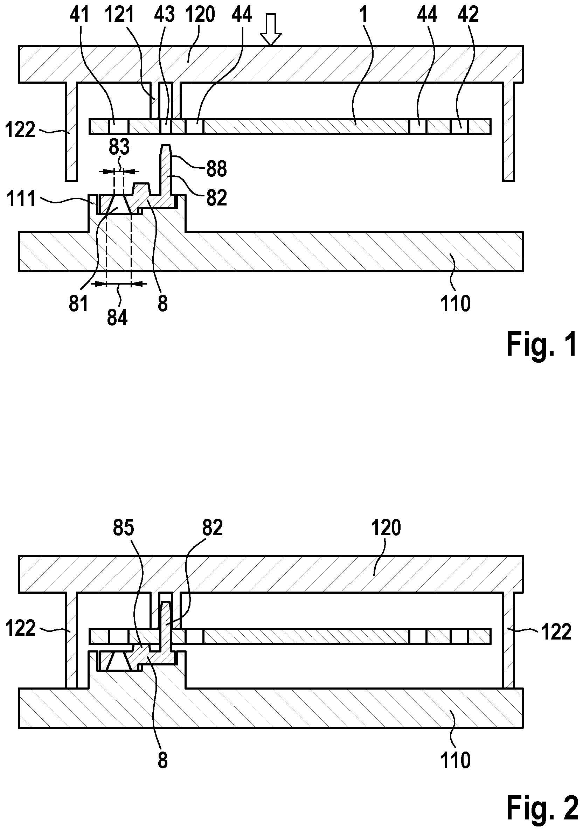

Figur 1 zeigt einen Querschnitt durch eine Leiterplatte 1. Die Leiterplatte kann beispielsweise eine konventionelle Leiterplatte (pcb = printed circuit board) sein, insbesondere Mehrlagenleiterplatte aus Epoxidharz mit Innenlagen aus Kupfer. Die Leiterplatte 1 kann mit den nicht dargestellten Bauelementen einer elektronischen Steuerschaltung bestückt sein oder bestückt werden. Die Leiterplatte 1 weist beispielsweise wenigstens zwei durchgehende Kontaktierungsöffnung 41 auf, von denen in Figur 1 nur eine dargestellt ist. Die Kontaktierungsöffnungen 41 der Leiterplatte können auf ihren Innenwandungen mit elektrisch leitendem Material beschichtet sein und mit Leiterbahnen der Leiterplatte 1 elektrisch leitend verbunden sein. Weiterhin weist die Leiterplatte 1 weitere Kontaktierungsöffnungen 42 auf, welche in gleicher Weise mit Leiterbahnen der Leiterplatte 1 verbunden sein können. Außer den Kontaktierungsöffnungen 41 und den weiteren Kontaktierungsöffnungen 42 weist die Leiterplatte 1 außerdem Befestigungsöffnungen 43, 44 auf, die keine metallisierten Innenwandungen und keine elektrische Leitfähigkeit aufweisen brauchen und die lediglich der mechanischen Befestigung dienen können.

Wie in Figur 1 weiterhin erkennbar ist, ist ein Drahtführungselement 8 vorgesehen. Dieses kann beispielsweise als einfaches Spritzgussteil aus Kunststoff gefertigt sein. Das Drahtführungselement 8 weist beispielsweise zwei von dem Drahtführungselement 8 abstehende Befestigungszapfen 82 auf (von denen nur einer in Figur 1 erkennbar ist), welche an ihrer Außenfläche mit Quetschrippen 88 versehen sein können. Weiterhin weist das Drahtführungs-element 8 wenigstens eine konusförmige Einfädelöffnung 81 mit einem ersten Innendurchmesser 83 und einem zweiten Innendurchmesser 84 auf, der größer als der erste Innendurchmesser 83 ist. Das Drahtführungselement 8 kann in eine Aufnahme 111 eines Trägerteils 110 eingelegt werden und kann darin seitlich gehalten und fixiert werden. Die Leiterplatte 1 wird in eine als Gegenstück zu dem Trägerteil 110 dienendes Halteteil 120 eingelegt und dort gehalten. Das Halteteil 120 kann einen hohlzylinderförmigen Vorsprung 121 aufweisen, welcher die Leiterplatte 1 in der Umgebung der Befestigungsöffnung 43 abstützt. Weiterhin weist das Halteteil 120 von diesem abstehende Anschläge 122 auf. Das Halteteil 122 wird, wie in Figur 1 dargestellt, über das Trägerteil 111 geführt, so dass die Leiterplatte 1 dem Drahtführungselement 8 zugewandt ist.

Durch relative Annäherung des Halteteils 120 und des Trägerteils 110 bis zur Anlage der Anschläge 122 an dem Trägerteil 110, wie in Figur 2 gezeigt, wird der Befestigungszapfen 82 in die Befestigungsöffnung 42 der Leiterplatte 1 eingepresst. Dabei verkrallen sich die Quetschrippen in der Befestigungsöffnung 42, so dass das Drahtführungselement 8 fest mit der Leiterplatte 1 verbunden ist. Ein von dem Drahtführungselement 8 vorstehende Stützrippe 85 kann an der Leiterplatte 1 zur Anlage gelangen. Danach kann das Trägerteil 110 und das Halteteil 120 entfernt werden.

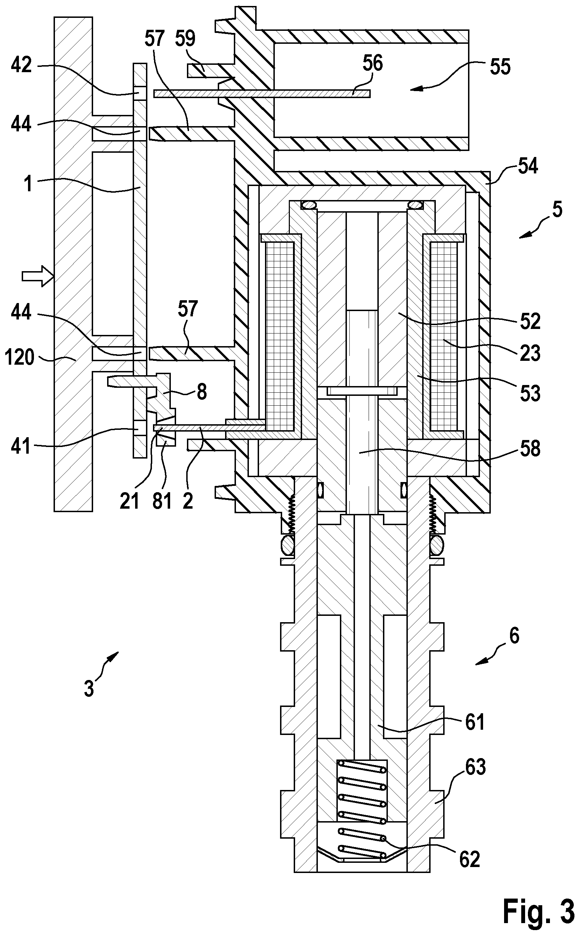

Die Leiterplatte 1 kann, wie in Figur 3 darstellt ist, in ein weiteres Halteteil 120 eingesetzt werden und an einem elektrohydraulischen Aktuator 3 montiert werden. Der elektrohydraulische Aktuator 3 kann ein Ventilteil 6, einen Elektromagneten 5 mit einer Spulenwicklung 23, einen in dem Elektromagneten 5 beweglich gelagerten Magnetanker 52 sowie ein von dem Magnetanker 52 betätigtes und in dem Ventilteil 6 angeordnetes Ventilglied 61 aufweisen, welches sich in dem Ventilteil 6 gegen eine Feder 62 abstützt. Das Ventilteil 6 kann aber auch anschließend montiert werden. Durch eine Verschiebung des Ventilgliedes 61 lassen sich nicht dargestellte Zulauföffnungen und Ablauföffnungen des Ventilteils 6 für ein Hydraulikfluid öffnen oder verschließen, wodurch der hydraulische Arbeitsdruck an einem Arbeitsanschluss des Ventilteils 6 eingestellt werden kann. Der Elektromagnet 5 ist vorzugsweise mit einem als Kunststoffgehäuse insbesondere im Spritzguss ausgebildeten Aktuatorgehäuse 54 versehen. Der Elektromagnet 5 umfasst beispielsweise ein Polrohr 53 in dem der Magnetanker 52 beweglich gelagert ist. Der Magnetanker 52 ist mit einem Stößel 58 fest verbunden, welcher an einem axialen Ende des Polrohrs 53 aus diesem hervorsteht und das Ventilglied 61 beaufschlagt. Das Polrohr 53 ist von einer Magnetspule mit der Spulenwicklung 23 umgeben. Durch Bestromung der Spulenwicklung 23 wird der Magentanker 52 in Figur 3 nach unten bewegt. Dadurch drückt der Stößel 58 das Ventilglied 61 entgegen der Federkraft der Feder 62 in dem Ventilteil 6 nach unten. Durch Verringerung der Stromstärke wird die Magnetkraft reduziert und das Ventilglied 61 wird mit Unterstützung der Spannkraft der Feder 62 in Figur 3 wieder nach oben bewegt.

Wie in Figur 3 weiterhin zu erkennen ist, weist die Spulenwicklung 23 wenigstens einen Anschlussdraht 2 auf, der seitlich aus dem Aktuatorgehäuse 54 herausgeführt ist, so dass ein Kontaktabschnitt 21 des wenigstens einen Anschlussdrahtes 2 der Spulenwicklung 23 seitlich von dem Aktuatorgehäuse 54 absteht. Der Kontaktabschnitt 21 kann von einem Isolationsmaterial oder einem Isolationslack der Spulenwicklung 23 befreit werden, so dass er als blanker Metalldraht vorliegt. Außerdem weist das Aktuatorgehäuse 54 mehrere seitlich von dem Aktuatorgehäuse 54 abstehende Haltezapfen 57 auf und mehrere Abstandshalter 59 sowie einen Anschlussstecker 55 auf. Steckerfahnen 56 des Anschlusssteckers 55 sind beispielsweise als Stanzgitterteile ausgebildet und mit ihrem Mittelabschnitten in den Kunststoff des Aktuatorgehäuses 54 eingespritzt. Erste Enden der Steckerfahnen 56 sind in dem Steckersteil 55 angeordnet und dienen zur Außenkontaktierung. Die davon abgewandten zweiten Enden der Steckerfahnen 56 stehen an dem Aktuatorgehäuse 54 in der gleichen Richtung ab, wie die Haltezapfen 54, der Kontaktabschnitt 21 des Anschlussdrahtes 2 und die Abstandshalter 59.

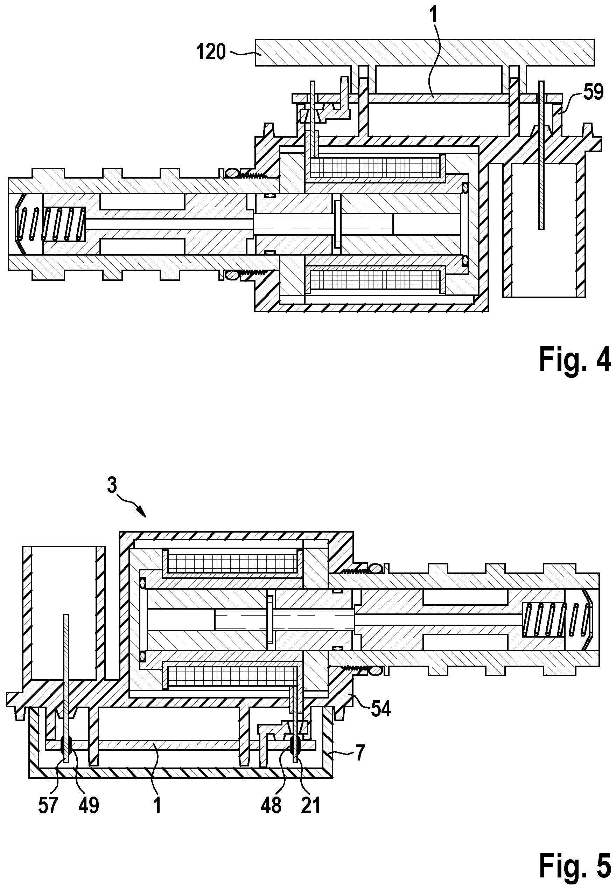

Wie in Figur 3 dargestellt ist, wird die Leiterplatte 1 mittels des Halteteils 120 auf die Haltezapfen 57 in der Pfeilrichtung aufgepresst, bis die Leiterplatte 1 in der in Figur 4 gezeigten Position an den Abstandhaltern 59 zur Anlage gelangt. Die Haltezapfen 57 dringen dabei in die Befestigungsöffnungen 44 der Leiterplatte 1 ein, so dass die Leiterplatte 1 durch Presspassung an den Haltezapfen 57 festgelegt wird. Bei dem Pressvorgang werden die Enden der Steckerfahnen 59 automatisch in die weiteren Kontaktierungsöffnungen 42 eingeschoben, während der Kontaktabschnitt 21 des wenigstens einen Anschlussdrahtes 2 die Einfädelöffnung 81 durchdringt und in die Kontaktierungsöffnung 41 eingeführt wird. Dabei erleichtert die konische Form der Einfädelöffnung die Einführung des biegeschlaffen Kontaktabschnitts 21, so dass diese nicht abknicken kann und nicht beschädigt wird. Selbstverständlich können weitere Kontaktabschnitte weiterer Anschlussdrähte der Spulenwicklung 23 in entsprechender Weise in diesen zugeordnete Einfädelöffnungen des Drahtführungsteils 8 und Kontaktierungsöffnungen der Leiterplatte 1 eingefädelt werden. Das Drahtführungsteil 8 kann beispielsweise alle Einfädelöffnungen für die Anschlussdrähte der Spulenwicklung 23 aufweisen. Es können alternativ aber auch mehrere Drahtführungsteile 8 auf der Leiterplatte angeordnet sein.

Nach dem Aufpressen der Leiterplatte 1 kann nunmehr das Halteteil 120 entfernt werden und der elektrohydraulische Aktuator 3 gegebenenfalls für ein anschließendes Lötverfahren gedreht werden, wie dies in Figur 5 dargestellt ist. In Figur 5 wirkt die Gravitation beispielsweise senkrecht von oben nach unten. Dies vereinfacht eine Verlötung des Kontaktabschnitts 21 mit der Kontaktierungsöffnung 41 an der Position 48 und gleichzeitig eine Verlötung der Steckerfahnen 57 mit den weiteren Kontaktierungsöffnungen 42 an der Position 49. Die Lötungen können vorzugsweise gemeinsam beispielsweise durch einen Tauchbadlöten vorgenommen werden. Zuletzt wird ein Gehäuseteil 7, wie in Figur 5 dargestellt ist, über die Leiterplatte 1 geschoben und an dem Aktuatorgehäuse 54 befestigt. Das Gehäuseteil 7 kann als Gehäusehalbschale aus Kunststoff ausgebildet sein und unter Zwischenlage einer nicht dargestellten Dichtung an dem Aktuatorgehäuse 54 befestigt werden.

## Patentansprüche

1. Elektrohydraulischer Aktuator (3) aufweisend einen Ventilteil (6), einen Elektromagneten (5) mit einer Spulenwicklung (23), einen in dem Elektromagneten (5) beweglich gelagerten Magnetanker (52) sowie ein von dem Magnetanker (52) betätigtes und in dem Ventilteil (6) angeordnetes Ventilglied (61), **dadurch gekennzeichnet, dass** an dem elektrohydraulischen Aktuator (3) wenigstens eine Leiterplatte (1) angeordnet ist, wobei die Leiterplatte (1) auf einer dem Elektromagneten (5) zuweisenden Seite ein auf der Leiterplatte (1) montiertes Drahtführungselement (8) aufweist, wobei das Drahtführungselement (8) wenigstens eine Einfädelöffnung (81) aufweist, wobei ein Kontaktabschnitt (21) eines Anschlussdrahts (2) der Spulenwicklung (23) durch die Einfädelöffnung (81) des Drahtführungselementes (8) hindurchgeführt und in eine Kontaktierungsöffnung (41) der Leiterplatte (1) eingelötet ist.

2. Elektrohydraulischer Aktuator nach Anspruch 1, **dadurch gekennzeichnet, dass** das Drahtführungselement (8) wenigstens einen in die Leiterplatte (1) eingepressten mit Quetschrippen (88) versehenen Befestigungszapfen (82) aufweist und vorzugsweise aus Kunststoff gefertigt ist.

3. Elektrohydraulischer Aktuator nach einem der vorstehenden Ansprüche, **dadurch gekennzeichnet, dass** die Einfädelöffnung (81) konusförmig mit einem der Leiterplatte (1) zugewandten ersten Innendurchmesser (83) und einem von der Leiterplatte (1) abgewandten zweiten Innendurchmesser (84), der größer als der erste Innendurchmesser (83) ist, ausgebildet ist.

4. Elektrohydraulischer Aktuator nach einem der vorstehenden Ansprüche, **dadurch gekennzeichnet, dass** die Leiterplatte (1) auf seitlich abstehende Haltezapfen (57) eines den Elektromagneten (5) bergenden Aktuatorgehäuses (54) aufgepresst ist und von einem an dem Aktuatorgehäuse (54) montierten Gehäuseteil (7) abgedeckt ist.

5. Elektrohydraulischer Aktuator nach einem der vorstehenden Ansprüche, **dadurch gekennzeichnet, dass** der Kontaktabschnitt (21) des Anschlussdrahts (2) der Spulenwicklung (23) in einer Richtung in die Kontaktierungsöffnung (41) eingeführt ist und Steckerfahnen (56) eines Anschlusssteckers (55) des elektrohydraulischen Aktuators (3) in der gleichen Richtung in weitere Kontaktierungsöffnungen (42) der Leiterplatte (1) eingeführt sind.

6. Verfahren zur Herstellung eines elektrohydraulischen Aktuators (3) nach einem der Ansprüche 1 bis 5, **gekennzeichnet durch** die folgenden Schritte:
- Bereitstellen einer Leiterplatte (1), wobei die Leiterplatte (1) wenigstens eine Kontaktierungsöffnung (41) aufweist,
- Bereitstellen eines elektrohydraulischen Aktuators (3) aufweisend einen Ventilteil (6), einen Elektromagneten (5) mit einer Spulenwicklung (23), einen in dem Elektromagneten (5) beweglich gelagerten Magnetanker (52) sowie ein von dem Magnetanker (52) betätigtes und in dem Ventilteil (6) angeordnetes Ventilglied (61), wobei der Elektromagnet (5) in einem Aktuatorgehäuse (54) aufgenommen ist und ein Kontaktabschnitt (21) eines Anschlussdrahts (2) der Spulenwicklung (23) seitlich von dem Aktuatorgehäuse (54) absteht,
- Bereitstellen eines Drahtführungselements (8), welches wenigstens eine Einfädelöffnung (81) aufweist,
- Befestigen des Drahtführungselementes (8) an der Leiterplatte (1), so dass die Einfädelöffnung (81) koaxial zu der Kontaktierungsöffnung (41) angeordnet ist,
- Aufsetzen der Leiterplatte (1) auf das Aktuatorgehäuse (54), so dass der von dem Aktuatorgehäuse (54) abstehende Kontaktabschnitt (21) durch die Einfädelöffnung (81) des Drahtführungselementes (8) hindurchgeführt und in eine Kontaktierungsöffnung (41) der Leiterplatte (1) eingeführt wird und
- Einlöten des Kontaktabschnitts (21) in der Kontaktierungsöffnung (41).

7. Verfahren nach Anspruch 6, **dadurch gekennzeichnet, dass** das Drahtführungselement (8) einen mit Quetschrippen (88) versehenen Befestigungszapfen (82) aufweist, der zur Befestigung des Drahtführungselementes (8) in eine Befestigungsöffnung (43) der Leiterplatte (1) eingepresst wird.

8. Verfahren nach einem der Ansprüche 6 oder 7, **dadurch gekennzeichnet, dass** die Leiterplatte (1) auf seitliche abstehende Haltezapfen (57) des den Elektromagneten (5) bergenden Aktuatorgehäuses (54) aufgepresst wird.

9. Verfahren nach einem der Ansprüche 6 bis 8, **dadurch gekennzeichnet, dass** der elektrohydraulische Aktuator (3) einen Anschlussstecker (55) aufweist, wobei Steckerfahnen (56) des Anschlusssteckers (55) in der gleichen Richtung wie der Kontaktabschnitt (21) des Anschlussdrahts (2) der Spulenwicklung (23) seitlich von dem Aktuatorgehäuse (54) abstehen und wobei in dem Schritt des Aufsetzens der Leiterplatte (1) auf das Aktuatorgehäuse (54) gleichzeitig mit der Einführung des Kontaktabschnitts (21) des Anschlussdrahts (2) in die Kontaktierungsöffnung (41) der Leiterplatte (1) und in der gleichen Richtung die Steckerfahnen (56) des Anschlusssteckers (56) in die weiteren Kontaktierungsöffnungen (42) der Leiterplatte (1) eingeführt werden.

10. Verfahren nach Anspruche 9, **dadurch gekennzeichnet, dass** der Kontaktabschnitt (21) mit der Kontaktierungsöffnung (41) und die Steckerfahnen (56) mit den weiteren Kontaktierungsöffnungen (42) verlötet werden.

11. Verfahren nach einem der Ansprüche 6 bis 10, **dadurch gekennzeichnet, dass** ein die Leiterplatte (1) abdeckendes Gehäuseteil (7) an dem Aktuatorgehäuse (54) befestigt wird.
